Europäisches Patentamt

European Patent Office

Office européen des brevets

(19)

(11) Veröffentlichungsnummer: **0 036 476**
**B1**

## EUROPÄISCHE PATENTSCHRIFT

(12)

(45) Veröffentlichungstag der Patentschrift:
**25.09.85**

(51) Int. Cl.⁴: **G 01 S 7/02**, G 01 S 13/50,
H 01 Q 1/24, H 03 B 9/14

(21) Anmeldenummer: **81100637.8**

(22) Anmeldetag: **29.01.81**

(54) **Mikrowellen-Sende-Empfänger, insbesondere für ein Doppler-Radar-System.**

(30) Priorität: **22.03.80 DE 3011238**

(43) Veröffentlichungstag der Anmeldung:
**30.09.81 Patentblatt 81/39**

(45) Bekanntmachung des Hinweises auf die Patenterteilung:
**25.09.85 Patentblatt 85/39**

(84) Benannte Vertragsstaaten:
**CH DE FR GB LI NL SE**

(56) Entgegenhaltungen:
**FR - A - 2 122 341**
**FR - A - 2 368 151**
**US - A - 3 803 514**

**IEEE TRANSACTIONS ON MICROWAVE THEORY &
TECHNIQUES, Band MTT-27, Nr. 10, Oktober 1979,
Seiten 844-847, New York, U.S.A., S.P. KWOK und K.P.
WELLER: "Low cost X-Band MIX BARRIT doppler
sensor"**

(73) Patentinhaber: **Licentia Patent-Verwaltungs-GmbH,
Theodor-Stern-Kai 1, D-6000 Frankfurt/Main 70 (DE)**

(72) Erfinder: **Lindner, Kurt, Dipl.-Ing., Elchinger Weg 6,
D-7900 Ulm (DE)**
Erfinder: **Schütz, Theodor, Ing. grad., Geroldstrasse 24,
D-8900 Memmingen (DE)**

(74) Vertreter: **Schickle, Gerhard, Dipl.-Ing. et al, Licentia
Patent-Verwaltungs-GmbH Theodor-Stern-Kai 1,
D-6000 Frankfurt/Main 70 (DE)**

**Beschreibung**

Die Erfindung bezieht sich auf einen Mikrowellen-Sende-Empfänger, wie im Oberbegriff des Patentanspruchs 1 angegeben. Ein solcher Sende-Empfänger ist aus der FR-A 21 22 341 bekannt. Ein ähnlicher Sende-Empfänger ist weiterhin in der DE-AS 21 26 470 in der Beschreibungseinleitung erwähnt und in der DE-OS 19 45 545 näher beschrieben.

Aus der FR-A-21 22 341 ist ein Mikrowellen-Sende-Empfänger bekannt, der als strahlendes Element eine Scheibe-Spiraldipol-Anordnung besitzt.

Nachteilig an dieser Anordnung ist, dass durch das Aufbringen der spiralförmigen Dipolstruktur auf die dielektrische Scheibe eine rotationssymmetrische Charakteristik nicht erreicht wird.

Ausserdem besitzt eine solche Antennencharakteristik, insbesondere die Anordnung mit einer solchen exzentrischen Einspeisung, ein Maximum senkrecht zur Scheibenoberfläche. Dies hat bei mit einem Doppler-Radar-System ausgestatteten Flugkörpern den Nachteil, dass ein Grossteil der Abstrahlenergie nicht genutzt werden kann, beispielsweise beim Messen der Geschwindigkeit vorbeifliegender Objekte.

Da die Grundfläche der dielektrischen Antenne nicht wesentlich grösser ist als die Oberfläche des angrenzenden Streifenleiters des Halbwellenresonators, ist eine optimale elektromagnetische Ankopplung zwischen Halbwellenresonator und dielektrischer Antenne damit nicht möglich.

Der in der FR-A-23 68 151 dargestellte Millimeterwellengenerator besitzt ebenfalls eine annähernd rotationssymmetrische zum Resonator angeordnete Diode, die zur Entdämpfung des Resonanzkreises und zur Schwingungsanregung dient.

Jedoch sitzt die Diode in einem Hohlraumresonator, der mechanisch und elektromagnetisch mit einer darüber angeordneten dielektrischen Antenne, deren Grundfläche nicht wesentlich grösser ist als die angrenzende Hohlraumresonatoroberfläche, verkoppelt ist. Nachteilig ist, dass eine solche Anordnung eine E11-Resonanz mit Strahlungsmaximum in Längsrichtung der Antenne entstehen lässt. Deshalb kann ein Grossteil der Abstrahlenergie auch hier nicht genutzt werden, beispielsweise bei der Gewinnung der Dopplerinformation während der Annäherung an vorbeifliegende Objekte.

Grob gesagt geht die Erfindung also aus von einem Mikrowellen-Sende-Empfänger mit selbstschwingender Halbleitermischstufe mit nicht linearer Mikrowellendiode in einem Resonator. Die von dieser Anordnung erzeugte Oszillatorschwingung wird über eine Antenne ausgesendet und nach Reflexion an einem zu ortenden Objekt von derselben Antenne wieder empfangen und nun von derselben Anordnung, die zur Erzeugung der auszusendenden Oszillatorschwingung dient und die jetzt als Mischstufe benutzt wird, mit der Oszillatorschwingung gemischt. Die durch die Mischung entstehende Schwingung im Zwisenfrequenzbereich ist das Dopplersignal, welches die Differenzfrequenz zwischen der ausgesendeten und der empfangenen Schwingung erkennen lässt und damit ein Mass für die Relativgeschwindigkeit des zu ortenden Objektes ist.

Die Oszillatorschwingung ist also sowohl Sende- als Lokaloszillator-Schwingung für die als Mischer wirkende Mikrowellendiode, die zugleich auch entdämpfend an der Schwingungserzeugung im Resonator beteiligt ist. Mikrowellendioden (z.B. Baritt-, Gunn-, Impatt-, Tunneldioden) können nämlich bei entsprechender Anpassung Resonatoren entdämpfen und zum Schwingen anregen. Aufgrund ihrer nichtlinearen Eigenschaften sind sie ausserdem in der Lage, als Empfängermischer zu arbeiten und lassen den Betrieb als selbstschwingende Mischstufe zu.

Als Anwendungsgebiete für den bekannten Sende-Empfänger kommen Radargeräte, z.B. Doppler-Radar-Systeme, zum Messen der Geschwindigkeit eines Objektes in Frage, beispielsweise zur Verhütung von Diebstählen, zur Verhütung von Kollisionen im Strassenverkehr oder schienengebundenen Verkehr, aber auch zur Geschwindigkeitserfassung von Projektilen, in welchen ein solcher Sende-Empfänger eingebaut sein kann.

Bei einigen der möglichen Anwendungsgebiete ist es wichtig, dass ein solcher Sende-Empfänger klein und einfach und damit billig aufgebaut ist.

Dementsprechend ist es Aufgabe der Erfindung, einen möglichst kleinen und sowohl mechanisch als auch elektrisch einfach aufgebauten Mikrowellen-Sende-Empfänger der im Oberbegriff des Patentanspruches 1 angegebenen Art zu schaffen.

Erfindungsgemäss wird diese Aufgabe gelöst durch den Mikrowellen-Sende-Empfänger mit den Merkmalen des Patentanspruches 1. Die Grundgedanken sind dabei folgende: Zur Vereinfachung und Verkleinerung des mechanischen und elektrischen Aufbaus dient nun als Resonator ein Halbwellenresonator, der als Streifenleitungsstück ausgebildet ist, in welchem die Mikrowellendiode zwischen den beiden Streifenleitern elektrisch leitend eingefügt ist; dabei ist auf einem Streifenleiter unmittelbar eine dielektrische Antenne angeordnet, während eine Diodenzuleitung durch den Resonator hindurch auf die andere Seite der Streifenleitung geführt ist; dort befindet sich eine Hochfrequenzdrossel in der Diodenzuleitung, um die Ableitung der auszusendenden Mikrowellenenergien zu verhindern.

Vorteilhafte Weiterbildungen sind in den Unteransprüchen angegeben.

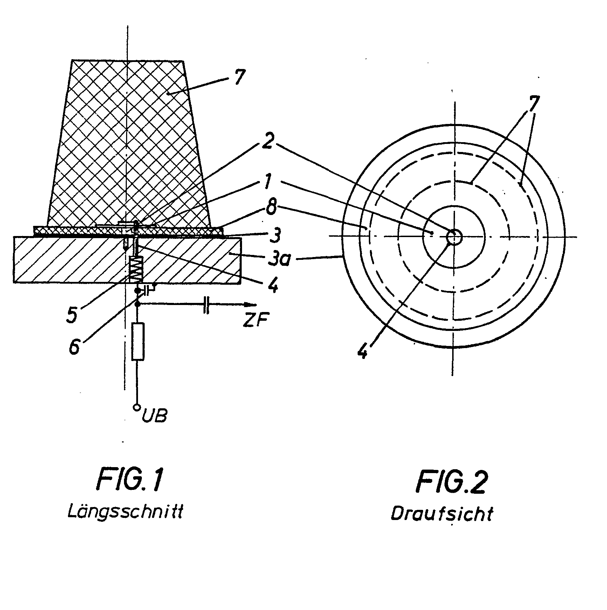

Anhand der Zeichnung wird ein Ausführungsbeispiel der Erfindung näher beschrieben, wobei
Figur 1 einen Längsschnitt und
Figur 2 eine Draufsicht bei durchsichtig gedachter dielektrischer Antenne darstellt.

In dem Ausführungsbeispiel ist ein runder Halbwellenresonator in Streifenleitungstechnik vorgesehen zwischen einem ersten Streifenleiter 1 und einem als Rückleiter 3 dienenden zweiten Streifenleiter mit dazwischen vorgesehenem dielektrischem Substrat 8. In der Mittelachse des Resonators befindet sich eine Mikrowellendiode 2, vorzugsweise in Barittausführung, die in den ersten Streifenleiter 1 eingelötet ist. Auf der anderen Seite des Resonators ist der Rückleiter 3 elektrisch und wärmeleitend mit einer Wärmesenke 3a verbunden, die elektrisch auf Bezugspotential (Masse) liegt und in der ein Teil der Mikrowellendiode 2 elektrisch leitend und wärmeleitend steckt, so dass die notwendige Wärmeabfuhr von der Mikrowellendiode gewährleistet ist. Das andere Ende der Mikrowellendiode, das mit dem ersten Streifenleiter 1 elektrisch verbunden ist, benötigt noch eine elektrische Zuleitung 4, die sowohl als Gleichspannungszuführung UB als auch als Zwischenfrequenzausgang ZF dient. Die Zuführung 4 besteht aus einem dünnen Draht, der durch eine Bohrung im Resonator und in der Wärmesenke 3a geführt ist, und zwar in unmittelbarer Nähe der Mikrowellendiode 2. Ein Abfliessen der im Resonator erzeugten Mikrowellenenergien über die Zuführung 4 wird durch eine Hochfrequenzdrossel 5 verhindert. Eventuell dennoch über diese Hochfrequenzdrossel gelangende Mikrowellenschwingungen werden mit einem Blockkondensator 6 kurzgeschlossen.

Eine dielektrische Antenne 7 von Kegelstumpfform ist mit einer Grundfläche, die grösser ist als diejenige des ersten Streifenleiters 1, direkt auf dem Resonator so angeordnet, dass eine leitungslose Ankopplung der elektromagnetischen Energie erfolgt. Dabei kann der Koppelgrad durch die Wahl der relativen Dielektrizitätskonstante des Kegelstumpfes, der hier als Antenne dient, und durch die Wahl des Materials des Substrates 8 beeinflusst werden; niedrige Werte der relativen Dielektrizitätskonstante des Antennenmaterials ergeben eine lose Ankopplung an den Resonator. Ebenso kann durch den resonatorseitigen Antennendurchmesser die Ankopplung variiert werden, weil insbesondere am hochohmigen Resonatorrand Feldlinien aus dem Substrat 8 in die Antenne gezogen werden können. Gewinn, Öffnungswinkel und Strahlungsdiagramm hängen weitgehend von der Dimensionierung der Antennenabmessungen ab und sind allgemein bekannt.

Bei im wesentlichen rotationssymmetrischer Ausbildung des Resonators und der Antenne und gegenseitiger koaxialer Zuordnung zusammen mit der Mikrowellendiode 2 ist es eine Eigenart der geschaffenen Anordnung, dass sich wegen der radial fliessenden Ströme im Resonator eine Nullstelle des Antennendiagramms in der Antennenlängsachse ergibt.

Die rotationssymmetrische Ausbildung ist von besonderem Vorteil, wenn die geschaffene Anordnung Anwendung findet in einem Flugkörper, der sich mit einem Drall um die Flugrichtung fortbewegt, beispielsweise in einem Geschoss, wobei dann die Antennenachse parallel zur Drallachse ausgerichtet sein sollte. Es ergibt sich auf diese Weise ein drallunabhängiges Antennendiagramm.

**Patentansprüche**

1. Mikrowellen-Sende-Empfänger, insbesondere für ein Doppler-Radar-System, mit einer selbstschwingenden Halbleitermischstufe, die einerseits zur Erzeugung der über eine auf einer Seite (1) einer Streifenleitung angeordneten dielektrischen Antenne (7) abzustrahlenden elektromagnetischen Schwingungen und andererseits zum Mischen der über dieselbe Antenne empfangenen Schwingungen mit den abzustrahlenden Schwingungen dient und als Halbleiter in einem Resonator (1, 8, 3) eine nichtlineare Mikrowellendiode, die zwischen zwei Streifenleitern (1, 3) der Streifenleitung elektrisch leitend eingefügt ist, sowohl zur Schwingungsentdämpfung als auch zur Mischung enthält sowie auf der antennenabgewandten Seite des Resonators eine Hochfrequenzdrossel (5) aufweist, die mit dem heissen Ende der Mikrowellendiode (2) elektrisch leitend mittels einer Diodenzuleitung (4) verbunden ist, gekennzeichnet durch folgende Merkmale:
a) als Resonator dient ein scheibenförmiger Halbwellenresonator, der die Streifenleitung (1, 8, 3) bildet,
b) der Resonator (1, 8, 3) und die Antenne (7) sind im wesentlichen rotationssymmetrisch aufgebaut und zusammen mit der Mikrowellendiode (2) koaxial angeordnet,
c) die Diodenzuleitung (4) ist in unmittelbarer Nähe der Mikrowellendiode (2) durch den Resonator hindurchgeführt,
d) die unmittelbar auf dem angrenzenden Streifenleiter (1) liegende Grundfläche der dielektrischen Antenne (7) ist deutlich grösser als die Oberfläche dieses Streifenleiters.

2. Mikrowellen-Sende-Empfänger nach Anspruch 1, dadurch gekennzeichnet, dass die dielektrische Antenne (7) ein Kegelstumpf aus einem Dielektrikum mit gegenüber Luft grösserer Dielektrizitätskonstante ist, der mit der grösseren seiner beiden Grundflächen auf dem genannten Streifenleiter (1) unmittelbar aufliegt.

3. Mikrowellen-Sende-Empfänger nach einem der vorangegangenen Ansprüche, dadurch gekennzeichnet, dass der andere Streifenleiter (3) ungefähr ebenso gross ist wie die benachbarte Grundfläche der Antenne (7).

4. Mikrowellen-Sende-Empfänger nach einem der vorangehenden Ansprüche, dadurch gekennzeichnet, dass der andere Streifenleiter (3) wärmeleitend mit einer Wärmesenke (3a) verbunden ist, in welche ein wärmeabgebender Teil der Mikrowellendiode (2) ragt.

5. Mikrowellen-Sende-Empfänger nach einem der vorangehenden Ansprüche, dadurch gekennzeichnet, dass die genannte Diodenzuleitung (4) Gleichspannungszuführung wie auch Ableitung für die durch die Mischung erzeugte Zwischenfrequenzschwingung (ZF) ist.

6. Mikrowellen-Sende-Empfänger nach einem der vorangehenden Ansprüche, dadurch gekennzeichnet, dass die genannte Diodenzuleitung (4) ausserhalb des Resonators (1, 8, 3) über einen Blockkondensator (6) elektrisch leitend mit dem anderen Streifenleiter (3) verbunden ist.

**Claims**

1. Microwave transmitter-receiver, particularly for a Doppler radar, with a self-oscillating semiconductor mixer stage, which serves on the one hand for the generation of the electromagnetic oscillations to be radiated away through a dielectric aerial (7) arranged on one side (1) of a strip line and on the other hand for the mixing of the oscillations received through the same aerial with the oscillations to be radiated away and which for regeneration of the oscillations as well as for mixing contains a non-linear microwave diode, which is inserted in electrically conductive manner between two strip conductors (1, 3) of the strip line, as semiconductor in a resonator (1, 8, 3) as well as on that side of the resonator, which is remote from the aerial, displays a high-frequency choke (5), which is connected in electrically conductive manner by means of a diode feed (4) with the hot end of the microwave diode (2) characterised by the following features:
   a) a disc-shaped half-wave resonator, which forms the strip line (1, 8, 3), serves as resonator,
   b) the resonator (1, 8, 3) and the aerial (7) are built-up substantially rotationally symmetrically and arranged co-axially together with the microwave diode (2),
   c) the diode feed (4) is led through the resonator in immediate proximity of the microwave diode (2) and
   d) the base surface of the dielectric aerial (7) lies directly on the adjacent strip conductor (1) and is appreciably greater than the surface of this strip conductor.

2. Microwave transmitter-receiver according to claim 1, characterised thereby, that the dielectric aerial (7) is a conical frustum of a dielectric with a dielectric co-efficient greater than that for air, which frustum rests by the greater of both its base surfaces directly on the said strip conductor (1).

3. Microwave transmitter-receiver according to one of the preceding claims, characterised thereby, that the other strip conductor (3) is approximately as great as the adjacent base surface of the aerial (7).

4. Microwave transmitter-receiver according to one of the preceding claims, characterised that the other strip conductor (3) is connected in thermally conductive manner with a heat sink (3a), into which a heat-delivering part of the microwave diode (2) projects.

5. Microwave transmitter-receiver according to one of the preceding claims, characterised thereby, that the said diode feed (4) is unindirectional voltage feed as well as also outlet for the intermediate frequency oscillation (ZF) produced by the mixing.

6. Microwave transmitter-receiver according to one of the preceding claims, characterised thereby, that the said diode feed (4) is connected externally of the resonator (1, 8, 3) with the other strip conductor (3) in electrically conductive manner by way of a blocking capacitor (6).

**Revendications**

1. Emetteur-récepteur hyperfréquences, destiné en particulier à un système de radar Doppler et comportant un étage mélangeur auto-oscillant à semiconducteurs, qui sert d'une part à produire les oscillations électromagnétiques rayonnées par une antenne diélectrique (7) disposée sur une face d'une ligne triplaque, et d'autre part à mélanger les oscillations reçues par la même antenne et les oscillations à rayonner, et comportant sous forme d'un semiconducteur dans un résonateur (1, 8, 3) un diode hyperfréquences non linéaire, insérée avec conduction électrique entre deux conducteurs (1, 3) de la ligne triplaque pour la compensation de l'atténuation des oscillations et pour mélange, ainsi qu'une bobine de réactance haute fréquence (5), disposée sur la face du résonateur opposée à l'antenne et reliée par une connexion (4) à l'extrémité sous tension de la diode hyperfréquences (2), ledit émetteur-récepteur étant caractérisé en ce que:
   a) le résonateur utilisé est un résonateur demionde en forme de disque, constitué par la ligne triplaque (1, 8, 3);
   b) le résonateur (1, 8, 3) et l'antenne (7) présentent une constitution sensiblement à symétrie de rotation et sont disposés coaxialement avec la diode hyperfréquences (2);
   c) la connexion (4) de diode traverse le résonateur au voisinage immédiat de la diode hyperfréquences (2); et
   d) la surface de base de l'antenne diélectrique (7), reposant directement sur le conducteur (1) adjacent, est nettement supérieure à la surface dudit conducteur.

2. Emetteur-récepteur hyperfréquences selon revendication 1, caractérisé en ce que l'antenne diélectrique (7) est un tronc de cône réalisé dans un diélectrique à constante diélectrique relative élevée et reposant directement sur ledit conducteur (1) par la plus grande de ses deux surfaces de base.

3. Emetteur-récepteur hyperfréquences selon une des revendications 1 ou 2, caractérisé en ce que le second conducteur (3) est sensiblement aussi grand que la surface de base voisine de l'antenne (7).

4. Emetteur-récepteur selon une quelconque des revendications 1 à 3, caractérisé en ce que le second conducteur (3) est relié avec conduction thermique à un puits thermique (3a) dans lequel pénètre une partie de la diode hyperfréquences (2) dissipant de la chaleur.

5. Emetteur-récepteur hyperfréquences selon une quelconque des revendications 1 à 4, caractérisé en ce que ladite connexion (4) de diode constitue la connexion d'alimentation en tension continue et la sortie de l'oscillation à fréquence intermédiaire (FI) produite par le mélange.

6. Emetteur-récepteur hyperfréquences selon une quelconque des revendications 1 à 5, caractérisé en ce que ladite connexion (4) de diode est, à l'extérieur du résonateur (1, 8, 3) reliée électriquement au second conducteur (3) par un condensateur de blocage (6).

**FIG.1**

*Längsschnitt*

**FIG.2**

*Draufsicht*